# EUROPEAN PATENT SPECIFICATION

(11) **EP 3 077 886 B1**
(45) Date of publication and mention of the grant of the patent: **04.12.2024**
(21) Application number: 14867589.5
(22) Date of filing: 31.01.2014
(51) Int. Cl.: G06F 1/20, H05K 7/20, G06F 9/445

(54) **METHODS AND SYSTEMS FOR MONITORING AND MANAGEMENT IN A DISTRIBUTED ARCHITECTURE INFORMATION HANDLING SYSTEM CHASSIS**
VERFAHREN UND SYSTEME ZUR ÜBERWACHUNG UND VERWALTUNG IN EINEM GESTELL EINES SYSTEM ZUR INFORMATIONSHANDHABUNG MIT VERTEILTER ARCHITEKTUR
PROCÉDÉS ET SYSTÈMES DE SURVEILLANCE ET DE GESTION DANS UN BÂTI DE SYSTÈME DE GESTION D'INFORMATIONS À ARCHITECTURE DISTRIBUÉE

(30) Priority: 05.12.2013 US 201314097784
(43) Date of publication of application: 12.10.2016
(73) Proprietor: Dell Products L.P., Round Rock, TX 78682-2244 (US)
(72) Inventor: MADDUKURI, Akkiah Choudary, Austin, Texas 78717 (US); MUGUNDA, Chandrasekhar, Austin, Texas 78717 (US); LILES, Terry Wayne, Round Rock, Texas 78717 (US); WEILNAU, JR. Wayne Robert, Austin, Texas 78717 (US); GNANASAMBANDAM, Balamurugan, Pondicherry 605005 (IN)
(74) Representative: Bardehle Pagenberg Partnerschaft mbB Patentanwälte Rechtsanwälte
(86) International application number: PCT/US2014/014130
(87) International publication number: WO 2015/084418

(56) References cited:
- US-A1- 2005 102 544
- US-A1- 2005 216 627
- US-A1- 2007 186 086
- US-A1- 2008 304 229
- US-B2- 7 555 666
- US-B2- 7 555 666
- US-B2- 7 669 071

## Description

### TECHNICAL FIELD

The present disclosure relates to modular information handling systems. More specifically, embodiments of the disclosure provide systems and methods for monitoring and management of chassis components in a distributed architecture information handling system chassis.

### BACKGROUND

As the value and use of information continues to increase, individuals and businesses seek additional ways to process and store information. One option available to users is information handling systems. An information handling system generally processes, compiles, stores, and/or communicates information or data for business, personal, or other purposes thereby allowing users to take advantage of the value of the information. Because technology and information handling needs and requirements vary between different users or applications, information handling systems may also vary regarding what information is handled, how the information is handled, how much information is processed, stored, or communicated, and how quickly and efficiently the information may be processed, stored, or communicated. The variations in information handling systems allow for information handling systems to be general or configured for a specific user or specific use such as financial transaction processing, airline reservations, enterprise data storage, or global communications. In addition, information handling systems may include a variety of hardware and software components that may be configured to process, store, and communicate information and may include one or more computer systems, data storage systems, and networking systems.

Existing server architectures either provide a single monolithic server capable of running one operating system (or a single hypervisor running multiple virtualized operating systems) and input/output ("I/O") resources at a time, or bulky blade server chassis providing multiple servers and I/O control modules in a single chassis. A system chassis with multiple information handling systems with various peripheral and I/O capabilities common to the chassis as a whole may provide advantages, as it allows a blade server chassis in a small form factor, thereby providing a blade server chassis with a size comparable to the size of a monolithic server. Implementation of a system chassis with multiple information handling systems with various peripheral and I/O capabilities common to the chassis as a whole presents numerous challenges.

US patent No. US 7 555 666 B2 discloses a method, system, and software instructions for allocating power in an information handling system, which are operable to respond to a power profiling request by transitioning a processing resource to a first power consumption state and obtaining and storing a first power consumption value.

US 2008/304229 A1 discloses systems and methods, which provide altitude-dependent fan control for a plurality of electronic subsystems using a shared air pressure sensor. Each server or multi-server chassis of a rack system is a subsystem of the rack system. Each subsystem receives its own on-board fan or blower module. The shared air pressure sensor senses air pressure and outputs a signal to all of the subsystems. Each subsystem then independently regulates its own fan speed according to the signal output by the shared air pressure sensor.

US 2007/186086 A1 discloses a baseboard management controller (BMC) of a blade server module in an information handling system.

US 2005/216627 A1 discloses a method for managing information from an operating system based environment includes determining whether the information is to be communicated to a chassis management module.

### SUMMARY

The invention is defined in the independent claims.

Preferred embodiments are defined in the dependent claims.

In the following, the parts of the description and drawings referring to embodiments which are not covered by the claims are not presented as embodiments of the invention but as background art or examples useful for understanding the invention.

In accordance with the teachings of the present disclosure, the disadvantages and problems associated with traditional approaches to monitoring and management in an information handling system chassis may be reduced or eliminated.

Technical advantages of the present disclosure may be readily apparent to one skilled in the art from the figures, description and claims included herein. The objects and advantages of the embodiments will be realized and achieved at least by the elements, features, and combinations particularly pointed out in the claims.

It is to be understood that both the foregoing general description and the following detailed description are examples and explanatory and are not restrictive of the claims set forth in this disclosure.

### BRIEF DESCRIPTION OF THE DRAWINGS

A more complete understanding of the present embodiments and advantages thereof may be acquired by referring to the following description taken in conjunction with the accompanying drawings, in which like reference numbers indicate like features, and wherein:
FIGURE 1 illustrates a cut-away perspective view of a chassis for receiving modular information handling resources, in accordance with embodiments of the present invention;
FIGURE 2 illustrates a perspective view of an example chassis drawer for carrying modular information handling resources, the drawer in an open position, in accordance with embodiments of the present invention;
FIGURE 3 illustrates a perspective view of an example chassis drawer for carrying modular information handling resources, the drawer in a closed position, in accordance with embodiments of the present invention;
FIGURE 4 illustrates a perspective view of another example chassis drawer for carrying information handling resources, in accordance with embodiments of the present invention;
FIGURE 5 illustrates an example functional block diagram of the chassis depicted in FIGURE 1 including a chassis drawer carrying a plurality of information handling systems, in accordance with embodiments of the present invention;
FIGURE 6 illustrates a flow chart of an example method for monitoring chassis-level sensors, in accordance with embodiments of the present invention;
FIGURE 7 illustrates a flow chart of an example method for management by a remote access controller of chassis-level information handling resources, in accordance with examples of the present disclosure; and
FIGURE 8 illustrates a flow chart of an example method for allocation of storage media associated with a chassis management controller to a remote access controller, in accordance with examples of the present disclosure.

### DETAILED DESCRIPTION

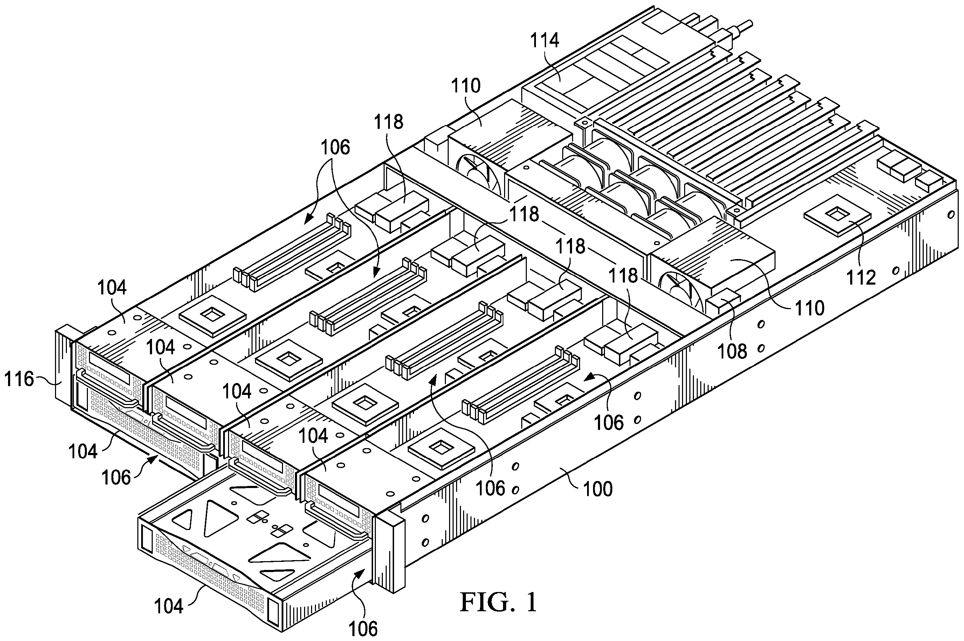

Preferred embodiments and their advantages are best understood by reference to FIGURES 1-8, wherein like numbers are used to indicate like and corresponding parts.

For the purposes of this disclosure, an information handling system may include any instrumentality or aggregate of instrumentalities operable to compute, classify, process, transmit, receive, retrieve, originate, switch, store, display, manifest, detect, record, reproduce, handle, or utilize any form of information, intelligence, or data for business, scientific, control, entertainment, or other purposes. For example, an information handling system may be a personal computer, a personal digital assistant (PDA), a consumer electronic device, a network storage device, or any other suitable device and may vary in size, shape, performance, functionality, and price. The information handling system may include memory, one or more processing resources such as a central processing unit (CPU) or hardware or software control logic. Additional components of the information handling system may include one or more storage devices, one or more communications ports for communicating with external devices as well as various input and output (I/O) devices, such as a keyboard, a mouse, and a video display. The information handling system may also include one or more busses operable to transmit communication between the various hardware components.

For the purposes of this disclosure, computer-readable media may include any instrumentality or aggregation of instrumentalities that may retain data and/or instructions for a period of time. Computer-readable media may include, without limitation, storage media such as a direct access storage device (e.g., a hard disk drive or floppy disk), a sequential access storage device (e.g., a tape disk drive), compact disk, CD-ROM, DVD, random access memory (RAM), read-only memory (ROM), electrically erasable programmable read-only memory (EEPROM), and/or flash memory; as well as communications media such as wires, optical fibers, microwaves, radio waves, and other electromagnetic and/or optical carriers; and/or any combination of the foregoing.

In this disclosure, the term "information handling resource" may broadly refer to any component system, device or apparatus of an information handling system, including without limitation processors, busses, memories, input-output devices and/or interfaces, storage resources, network interfaces, motherboards, electro-mechanical devices (e.g., fans), displays, and power supplies.

FIGURE 1 illustrates a perspective view of a chassis 100 for receiving modular information handling resources, in accordance with embodiments of the present invention, with certain elements (e.g., walls for enclosing components within chassis 100) cut-away or removed in order to show information handling resources internal to chassis 100. Chassis 100 may be an enclosure that serves as a container for various information handling systems and information handling resources, and may be constructed from steel, aluminum, plastic, and/or any other suitable material. Although the term "chassis" is used, chassis 100 may also be referred to as a case, cabinet, tower, box, enclosure, and/or housing. In certain embodiments, chassis 100 may be configured to hold and/or provide power to a plurality of information handling systems and/or information handling resources. As depicted in FIGURE 1, chassis 100 may include one or more slots 106 configured to receive drawers 104 for carrying information handling resources, as described in greater detail below. For example, some drawers 104 may include one or more information handling systems. As another example, some drawers 104 may include one or more peripherals (e.g., hard disk drives, graphics processing units, etc.) associated with information handling systems disposed in another drawer 104.

Each drawer 104 may include an interface connector 118 configured to electrically couple to a midplane 108, thus providing electrical coupling between information handling resources carried on the various drawers 104 to each other and/or one or more networks or devices external to chassis 100. Midplane 108 may comprise any system, device, or apparatus configured to interconnect information handling resources of chassis 100 with each other. Accordingly, midplane 108 may include slots, pads, and/or other connectors configured to receive corresponding electrical connectors of information handling resources in order to electrically couple information handling systems disposed in drawers 104 and/or information handling resources to each other.

A chassis management controller (CMC) 112 may be communicatively coupled to midplane 108 and may comprise any system, device, or apparatus configured to facilitate management and/or control of components of chassis 100, information handling systems modularly coupled within, and/or one or more of its component information handling resources. CMC 112 may be configured to issue commands and/or other signals to manage and/or control information handling systems coupled to slots 106 and/or information handling resources of chassis 100. CMC 112 may comprise a microprocessor, microcontroller, DSP, ASIC, field programmable gate array ("FPGA"), EEPROM, or any combination thereof.

In addition or alternatively, CMC 112 may also provide a management console for user/administrator access to these functions. For example, CMC 112 may provide for communication with a user interface (e.g., user interface 116), permitting a user to interact with CMC 112 and configure control and management of components of chassis 100 by CMC 112. As another example, CMC 112 may implement Web Services Management ("WS-MAN") or another suitable management protocol permitting a user to remotely access a CMC 112 to configure chassis 100 and its various information handling resources. A CMC 112 interfaces with a network interface separate from a traditional network interface of chassis 100, thus allowing for "out-of-band" control of chassis 100, such that communications to and from CMC 112 are communicated via a management channel physically isolated from an "in band" communication channel with the traditional network interface. Thus, for example, if a failure occurs in chassis 100 that prevents an administrator from interfacing with chassis 100 via a traditional network interface and/or user interface 116 (e.g., operating system failure, power failure, etc.), the administrator may still be able to monitor and/or manage chassis 100 (e.g., to diagnose problems that may have caused failure) via CMC 112. In the same or alternative embodiments, CMC 112 may allow an administrator to remotely manage one or more parameters associated with operation of chassis 100 and its various information handling resources (e.g., power usage, processor allocation, memory allocation, security privileges, etc.).

One or more air movers 110 may be communicatively coupled to CMC 112, and may include any mechanical or electro-mechanical system, apparatus, or device operable to move air and/or other gasses. In some embodiments, an air mover 110 may comprise a fan (e.g., a rotating arrangement of vanes or blades which act on the air). In other embodiments, an air mover 110 may comprise a blower (e.g., a centrifugal fan that employs rotating impellers to accelerate air received at its intake and change the direction of the airflow). In these and other embodiments, rotating and other moving components of an air mover 110 may be driven by a motor. The rotational speed of such motor may be controlled by one or more control signals communicated from CMC 112. In operation, an air mover 110 may cool information handling systems and information handling resources of chassis 100 by drawing cool air into chassis 100 from outside chassis 100, expel warm air from inside chassis 100 to the outside of chassis 100, and/or move air across one or more heatsinks (not explicitly shown) internal to chassis 100 to cool one or more information handling systems and/or information handling resources. Although FIGURE 1 depicts chassis 100 as having two air movers 110, chassis 100 may include any suitable number of air movers 110.

As shown in FIGURE 1, chassis 100 may include one or more power supplies 114. Generally speaking, a power supply 114 may include any system, device, or apparatus configured to supply electrical current to one or more information handling resources within chassis 100.

A user interface 116 may include any system, apparatus, or device via which a user may interact with chassis 100 and its various components by facilitating input from a user allowing the user to manipulate chassis 100 and output to a user allowing chassis 100 to indicate effects of the user's manipulation. For example, user interface 116 may include a display suitable for creating graphic images and/or alphanumeric characters recognizable to a user, and may include, for example, a liquid crystal display, a cathode ray tube, a plasma screen, and/or a digital light processor projection monitor. In certain embodiments, such a display may be an integral part of chassis 100 and receive power from one or more power supplies 114 of chassis 100, rather than being coupled to chassis 100 via a cable. In some embodiments, such display may comprise a touch screen device capable of receiving user input, wherein a touch sensor may be mechanically coupled or overlaid upon the display and may comprise any system, apparatus, or device suitable for detecting the presence and/or location of a tactile touch, including, for example, a resistive sensor, capacitive sensor, surface acoustic wave sensor, projected capacitance sensor, infrared sensor, strain gauge sensor, optical imaging sensor, dispersive signal technology sensor, and/or acoustic pulse recognition sensor. In these and other embodiments, user interface 116 may include other user interface elements (e.g., a keypad, buttons, and/or switches placed in proximity to a display) allowing a user to provide input to chassis 100. In these and other embodiments, user interface 116 may include one or more visual indicators, such as light-emitting diodes, for example, for communicating information to a user. User interface 116 may be coupled to CMC 112 and/or other components of chassis 100, and thus may allow a user to configure various information handling systems and/or information handling resources of chassis 100.

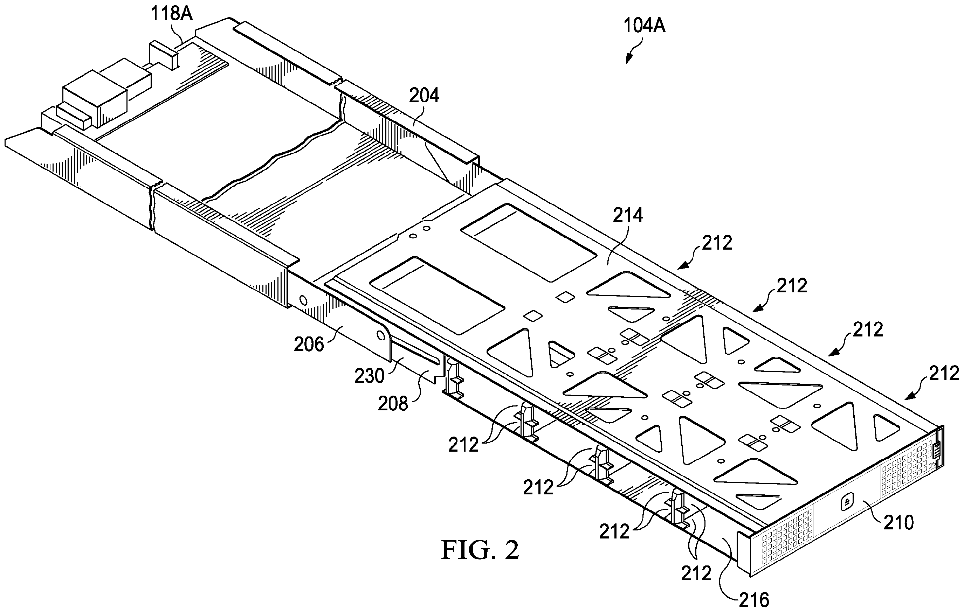

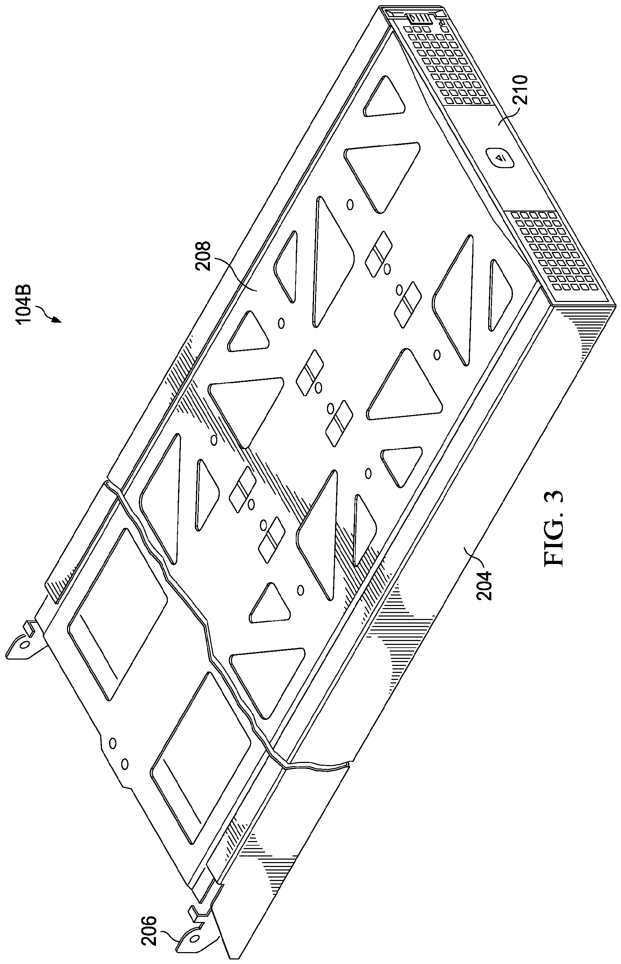

FIGURES 2 and 3 depict various views of an example chassis drawer 104A for carrying modular information handling resources, in accordance with embodiments of the present invention. FIGURE 2 illustrates a perspective view of an example chassis drawer 104A for carrying modular information handling resources, wherein drawer 104A is in an open position drawn from chassis 100, in accordance with embodiments of the present disclosure. FIGURE 3 illustrates a perspective view of chassis drawer 104A for carrying modular information handling resources, wherein drawer 104A is in a closed position relative to chassis 100, in accordance with embodiments of the present disclosure.

As shown in FIGURES 2 and 3, chassis drawer 104A may comprise an inner member 204, an intermediate member 206 mechanically coupled to inner member 204, and a carrier member 208 mechanically coupled to intermediate member 206. Inner member 204 may be constructed from steel, aluminum, plastic, and/or any other suitable material. Although inner member 204 may have any suitable size and/or shape, inner member 204 is depicted in the embodiments of FIGURES 2 and 3 as having two substantially planar and parallel opposite sides defining a drawer height coupled to each other by a substantially planar bottom generally perpendicular to the sides defining a drawer width and a guide flange extending from and running perpendicular to and along the length of each side such that the flanges project towards each other. In some embodiments, inner member 204 may be mechanically coupled to the internal mechanical structure of chassis 100, such that inner member 204 is fixed relative to chassis 100.

Intermediate member 206 may be constructed from steel, aluminum, plastic, and/or any other suitable material. Although intermediate member 206 may have any suitable size and/or shape, intermediate member 206 is depicted in the embodiments of FIGURES 2 and 3 as having two generally parallel and planar opposite sides coupled to each other by a substantially planar bottom generally perpendicular to the sides. The height of the sides and the width of the bottom may be such that the corresponding sides and bottom of inner member 204 provide a mechanical guide for intermediate member 206 as chassis drawer 104A is opened and closed. Intermediate member 206 may be mechanically coupled to inner member 204 via bearings and/or other mechanical components such that intermediate member 206 may slide relative to inner member 204 in a direction perpendicular to the drawer height and drawer width defined by inner member 204. In some embodiments, intermediate member 206 may be limited in the distance it may be drawn from chassis 100 through any combination of suitable structural elements. Similarly, in some embodiments, other mechanical components may restrict motion of intermediate member 206 relative to inner member 204 as chassis drawer 104A is translated from the open position to the closed position.

Carrier member 208 may be constructed from steel, aluminum, plastic, and/or any other suitable material. Although carrier member 208 may have any suitable size and/or shape, carrier member 208 is depicted in the embodiments of FIGURES 2 and 3 as having a substantially planar top 214 and a substantially planar bottom 216 generally parallel to each other defining a width and depth of carrier member 208, the top 214 and bottom 216 mechanically coupled to each other by one or more structural elements defining a height of carrier member 208, such that top 214 and bottom 216 are generally perpendicular to the sides of intermediate member 206. Carrier member 208 may also include a face 210 mechanically affixed to top 214 and/or bottom 216. As shown in FIGURES 2 and 3, top 214 may include one or more openings (e.g., above bays 212) allowing for gaseous fluid to pass through. Similarly, bottom 216 may also include one or more openings (e.g., below bays 212) allowing for gaseous fluid to pass through.

In some embodiments, face 210 may be substantially equal in width to the width of carrier member 208 and substantially equal to the height of carrier member 208. In these and other embodiments, face 210 may include handles, pull tabs, and/or other features allowing a person to pull on face 210 in order to translate chassis drawer 104A from a closed position to an open position in a direction generally parallel to the depth of top 214 and bottom 216. In these and other embodiments, face 210 may include a grill, vent, and/or other opening allowing gaseous fluid to enter and/or exit through face 210.

As shown in FIGURE 2, each side of carrier member 208 (e.g., portions of carrier member 208 between the edges of and substantially parallel to top 214 and bottom 216) may include a web 230 configured to mechanically couple carrier member 208 to intermediate member 206, as well as openings for a plurality of bays 212.

Each of the various bays 212 defined by drawer 104A may include one or more electrical components for coupling an information handling resource (e.g., a hard disk drive) inserted into such bay 212 to other information handling resources of chassis 100. For example, a backplane (not explicitly shown) may couple a modular information handling resource disposed in a bay 212 to interface connector 118A, which, as described above, may in turn be coupled to midplane 108. In some embodiments, the various information handling resources may be coupled to interface connector 118A such that when chassis drawer 104A is drawn open relative to chassis 100, such information handling resources maintain electrical conductivity to interface connector 118A and interface connector 118A may maintain electrical conductivity to midplane 108, thus permitting insertion or removal of an information handling resource without affecting operation of other information handling resources carried by chassis drawer 104A. In such embodiments, interface connector 118A may only be decoupled from midplane 108 when the entirety of chassis drawer 104A is removed from chassis 100.

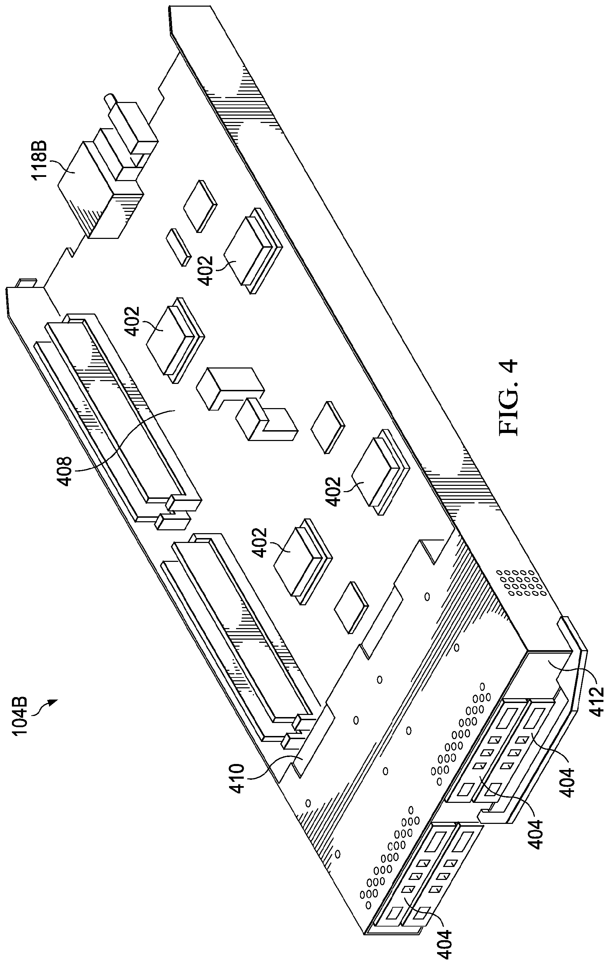

FIGURE 4 illustrates a perspective view of another example chassis drawer 104B for carrying information handling resources, in accordance with embodiments of the present invention. Although not labeled in detail as in FIGURES 2 and 3, chassis drawer 104B may include one or more mechanical and/or structural elements (e.g., similar or identical to inner member 204, intermediate member 206, and carrier member 208) for translating chassis drawer 104B between open and closed positions relative to chassis 100. Similar to chassis drawer 104A, the various information handling resources carried by chassis drawer 104B may be coupled to interface connector 118B such that when chassis drawer 104B is drawn open relative to chassis 100, such information handling resources maintain electrical conductivity to interface connector 118B and interface connector 118B may maintain electrical conductivity to midplane 108, thus permitting insertion or removal of an information handling resource without affecting operation of other information handling resources carried by chassis drawer 104B. In such embodiments, interface connector 118B may only be decoupled from midplane 108 when the entirety of chassis drawer 104B is removed from chassis 100.

In the particular chassis drawer 104B depicted in FIGURE 4, a backplane 408 may have thereon a plurality (e.g., four) of processors 402 and a chipset associated with each processor 402, thus defining four independent information handling systems carried by chassis drawer 104B. Interface connector 118B may also be coupled to backplane 408, thus coupling processors 402 to information handling resources of chassis 100 external to chassis drawer 104B. In addition, the particular chassis drawer 104B depicted in FIGURE 4 may include a plurality (e.g., four) of hard disk drives 404 communicatively coupled to backplane 408 (and thus one or more of processors 402) via a drive backplane 410.

As shown in FIGURE 4, chassis drawer 104B may comprise a user interface 412. User interface 412 may include any system, apparatus, or device via which a user may interact with compute nodes (e.g., via a remote access controller such as an Integrated Dell Remote Access Controller or "iDRAC" for example) of chassis drawer 104B and its various components by facilitating input from a user allowing the user to compute nodes and to indicate effects of the user's manipulation. For example, user interface 412 may include a display suitable for creating graphic images and/or alphanumeric characters recognizable to a user, and may include, for example, a liquid crystal display, a cathode ray tube, a plasma screen, and/or a digital light processor projection monitor. In some embodiments, such display may comprise a touch screen device capable of receiving user input, wherein a touch sensor may be mechanically coupled or overlaid upon the display and may comprise any system, apparatus, or device suitable for detecting the presence and/or location of a tactile touch, including, for example, a resistive sensor, capacitive sensor, surface acoustic wave sensor, projected capacitance sensor, infrared sensor, strain gauge sensor, optical imaging sensor, dispersive signal technology sensor, and/or acoustic pulse recognition sensor. In these and other embodiments, user interface 412 may include other user interface elements (e.g., a keypad, buttons, and/or switches placed in proximity to a display) allowing a user to provide input to one or more compute nodes of chassis drawer 104B. In these and other embodiments, user interface 412 may include one or more visual indicators, such as light-emitting diodes, for example, for communicating information to a user.

Although FIGURES 2-4 depict particular example chassis drawers 104, chassis drawers 104 with other configurations may be employed consistent with the systems and methods herein disclosed. For example, in some embodiments, a chassis drawer 104 similar to that of chassis drawer 104B may include only one processor, such that the chassis drawer includes one compute node.

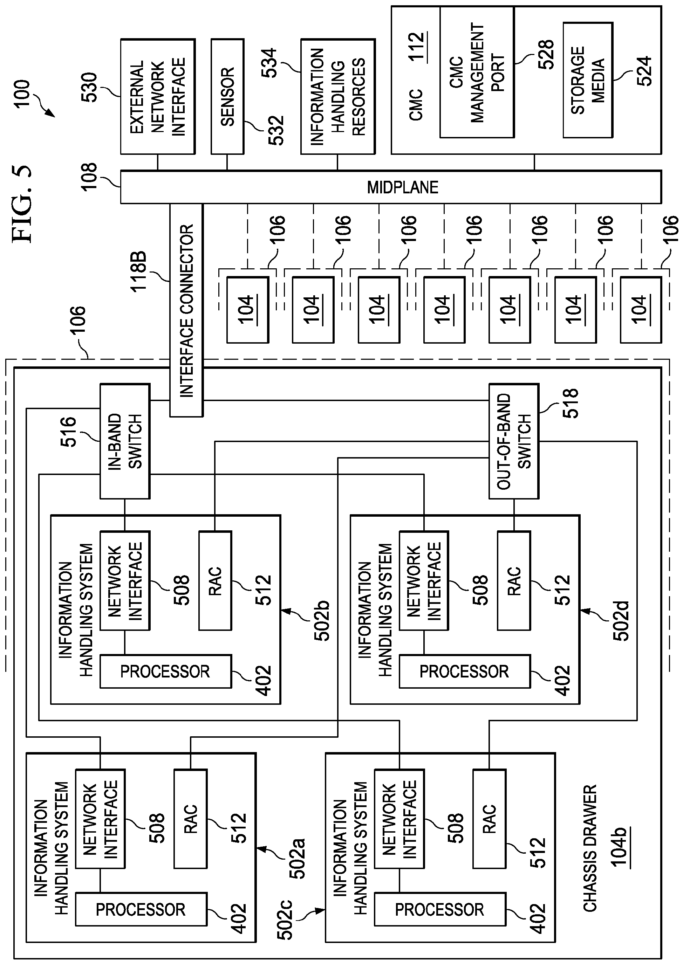

FIGURE 5 illustrates an example functional block diagram of chassis 100 depicted in FIGURE 1, wherein chassis 100 has disposed in one of its slots 106 a chassis drawer 104B carrying a plurality of information handling systems 502, in accordance with embodiments of the present invention.

As shown in FIGURE 5, chassis 100 may include other chassis drawers 104, wherein such chassis drawers 104 may carry information handling systems, hard disk drives, and/or other information handling resources which may or may not be similar to chassis drawers 104A and 104B described above.

As shown in FIGURE 5, chassis drawer 104B may include a plurality of information handling systems 502 (e.g., 502a-d), each of which may comprise a server or other suitable computing node, an in-band switch 516, an out-of-band switch 518, one or more sensor 532, and one or more other information handling resources 534. Among other components, an information handling system 502 may comprise a processor 402, a network interface 508 communicatively coupled to its associated processor 402, and a remote access controller (RAC) 512.

A processor 402 may include any system, device, or apparatus configured to interpret and/or execute program instructions and/or process data, and may include, without limitation, a microprocessor, microcontroller, digital signal processor ("DSP"), application specific integrated circuit ("ASIC"), or any other digital or analog circuitry configured to interpret and/or execute program instructions and/or process data. In some embodiments, processor 402 may interpret and/or execute program instructions and/or process data stored in a memory or other computer-readable media accessible to processor 402.

A network interface 508 may comprise any suitable system, apparatus, or device operable to serve as an interface between an associated information handling system 502 and a private communication network internal to chassis drawer 104B formed by information handling systems 502 and in-band switch 516. Network interface 508 may enable an associated information handling system 502 to communicate using any suitable transmission protocol and/or standard. In some embodiments, network interface 508 may comprise one or more network interface cards, or "NICs." In other embodiments, network interface 508 may comprise one or more local area network (LAN)-on-motherboard (LOM) devices. In these and other embodiments, network interface 508 may include a plurality of NICs, LOMs, or other network interface devices, in order to provide communication redundancy or robustness.

A RAC 512 may be implemented by, for example, a microprocessor, microcontroller, DSP, ASIC, EEPROM, or any combination thereof. RAC 512 may be configured to communicate with CMC 112. Such communication may be made, for example, via private management network fabric implemented using out-of-band switch 518. RAC 512 may be configured to provide out-of-band management facilities for management of an associated information handling system 502. Such management may be made by CMC 112 even if information handling system 502 is powered off or powered to a standby state. A RAC 512 may include a processor, memory, and network connection separate from the rest of its associated information handling system 502. In certain embodiments, A RAC 502 may include or may be an integral part of a baseboard management controller (BMC), Dell Remote Access Controller (DRAC) or an Integrated Dell Remote Access Controller (iDRAC).

In-band switch 516 may comprise any system, device, or apparatus configured to couple network interfaces 508 of information handling systems 502 to external network interface 530 and perform switching between network interfaces 508 and an external communication network communicatively coupled to external network interface 530 based on a network configuration of various ports (not explicitly shown) of network interfaces 508, in-band switch 516, and external network interface 530, as described in greater detail below. In-band switch 516 may comprise a PCIe switch, a generalized PC bus switch, an Infiniband switch, or other suitable switch.

Similarly, out-of-band switch 518 may comprise any system, device, or apparatus configured to couple RACs 512 of information handling systems 502 to CMC 112 and perform switching between RACs 512 and CMC 112 in order to provide for centralized management of individual information handling systems 502 via a management console coupled to CMC 112 (e.g., via CMC management port 528).

As shown in FIGURE 5, an external network interface 530 may be communicatively coupled to midplane 108. External network interface 530 may comprise any suitable system, apparatus, or device operable to serve as an interface between chassis 100 and a network external to chassis 100. External network interface 530 may enable an information handling system 502 to communicate with such external network using any suitable transmission protocol and/or standard. In some embodiments, external network interface 530 may comprise one or more network interface cards, or "NICs." In other embodiments, external network interface 530 may comprise one or more input/output module (IOM) devices. In these and other embodiments, external network interface 530 may include a plurality of NICs, IOMs, or other network interface devices, in order to provide communication redundancy or robustness.

In addition, as shown in FIGURE 5, CMC 112 may include storage media 524 and a CMC management port 528. Storage media 524 may include any system, device, or apparatus configured to retain program instructions and/or data for a period of time (e.g., computer-readable media). Storage media 524 may include RAM, EEPROM, a PCMCIA card, flash memory, magnetic storage, opto-magnetic storage, or any suitable selection and/or array of volatile or non-volatile memory that retains data after power to CMC 112 is turned off .

CMC management port 528 serves as a network interface between CMC 112 and a remote management console configured to allow a user to remotely manage components of chassis 100 via an out-of-band network physically isolated from an in-band network coupled to external network interface 530. CMC management port 528 may communicate with such remote management console via any suitable management protocol or standard, including without limitation Intelligent Platform Management Interface (IPMI) and Simple Network Management Protocol (SNMP).

Sensor 532 may be coupled to midplane 108 and may include any suitable system, device, or apparatus that measures a physical quantity and converts it into a signal which can be read by a processor 402, RAC 512, and/or CMC 112. For example, a sensor 532 may include a temperature sensor (e.g., thermocouple, thermistor, thermostat, etc.), a speed sensor (e.g., a Hall effect sensor used to determine rotational speed of an air mover (e.g., an air mover 110), or any other suitable sensor for detecting a physical quantity associated with chassis 100 or a component thereof. Based on a measured physical quantity of a sensor 532, an information handling system 502 or a component thereof may take an action. As an example, in embodiments in which sensor 532 comprises a temperature sensor, an information handling system 502 may take corrective or remedial action in response to a sensed temperature exceeding a threshold, such as causing an increase in speed of an air mover 110, reducing power consumption of an information handling system 502, and/or other remedial action. For simplicity of exposition, only one sensor is depicted in FIGURE 5. However, in embodiments of the present disclosure, a chassis 100 may include any number of any combination of types of sensors 532.

One or more information handling resources 534 may be communicatively coupled to midplane 108 or otherwise disposed in chassis 100 and may include one or more processors, service processors, basic input/output systems, buses, memories, I/O devices and/or interfaces, storage resources, network interfaces, motherboards, air movers, power supplies, and/or any other components and/or elements suitable for use in an information handling system. Such information handling resources 534 may also include air movers 110 and power supply 114 depicted in FIGURE 1 but not otherwise depicted in FIGURE 5. As is known in the art, some information handling resources 534 may operate in accordance with firmware instructions stored on a computer-readable medium integral to or otherwise accessible to the information handling resource.

Users of existing rack servers may be accustomed to monitoring and management of an information handling system chassis in which updates to information resources of a chassis are managed and applied by a RAC and which sensors are monitored by a RAC. However, in a distributed modular chassis system such as that depicted in FIGURES 1-5, such traditional approaches may not be desired or available, as a CMC may "own" such chassis-level sensors and information handling resources and thus the CMC is responsible for physical management and monitoring of such sensors and information handling systems.

In addition, users of existing rack servers may be accustomed to monitoring and management of an information handling system chassis in which RACs include computer-readable media for storing data and instructions locally to the RAC (e.g., via a flash or secure digital (SD) card). However, in a distributed modular chassis system such as that depicted in FIGURES 1-5, physical computer-readable media local to each RAC may not be desired or available, due to physical space limitations.

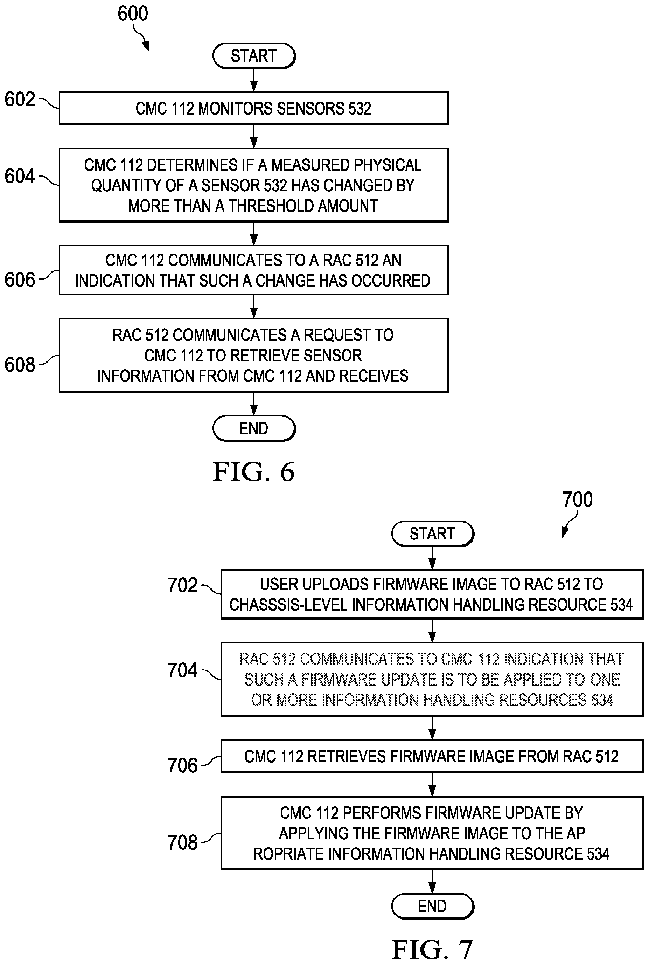

FIGURE 6 illustrates a flow chart of an example method 600 for monitoring chassis-level sensors 532, in accordance with embodiments of the present invention. According to some embodiments, method 600 may begin at step 602. As noted above, teachings of the present disclosure may be implemented in a variety of configurations of chassis 100. As such, the preferred initialization point for method 600 and the order of the steps comprising method 600 may depend on the implementation chosen.

At step 602, CMC 112 monitors one or more sensors 532 by receiving signals from the one or more sensors 532 indicative of the physical quantities measured by such sensors 532.

At step 604, CMC 112 may determine if a measured physical quantity of a sensor 532 has changed by more than a threshold amount. For example, for a temperature sensor, such threshold amount may be equal to five degrees Celsius. If such a change has occurred, method 600 may proceed to step 606. Otherwise, step 604 may repeat until such a change has occurred.

At step 606, responsive to a change of a measured physical quantity of a sensor 532 by more than the threshold amount, CMC 112 may communicate to a RAC 512 (e.g., via out-of-bound switch 518) present on a chassis drawer 104 disposed in chassis 100 an indication that such a change has occurred. Such indication may include an IPMI over LAN command or other suitable command communicated between CMC 112 and RAC 512 via out-of-band switch 518.

At step 608, responsive to receipt of the indication from CMC 112 that a change has occurred in a measured physical quantity of a sensor 532, RAC 512 may communicate a request to CMC 112 to retrieve (e.g., download) sensor information from CMC 112 and may receive the sensor information from CMC 112. Such download may be performed using trivial file transfer protocol (TFTP), IPMI over LAN, or other suitable protocol or standard for file transfer. RAC 512 may, alone or in concert with an associated processor 402, process the sensor information in order to model performance of chassis 100 components, initiate responsive action to a measured physical quantity, and/or perform any other action. Accordingly, a RAC 512 may model chassis 100 components in the same fashion as it would in a rack server. CMC 112 serves as a proxy between sensors 532 and RAC 512.

Although FIGURE 6 discloses a particular number of steps to be taken with respect to method 600, method 600 may be executed with greater or fewer steps than those depicted in FIGURE 6. In addition, although FIGURE 6 discloses a certain order of steps to be taken with respect to method 600, the steps comprising method 600 may be completed in any suitable order.

Method 600 may be implemented using CMC 112, a remote access controller 512, and/or any other system operable to implement method 600. In certain embodiments, method 600 may be implemented partially or fully in software and/or firmware embodied in computer-readable media and executable on a processor or controller.

FIGURE 7 illustrates a flow chart of an example method 700 for management of chassis-level information handling resources 534, in accordance with examples embodimenfeo of the present disclosure. According to some embodiments, method 700 may begin at step 702. As noted above, teachings of the present disclosure may be implemented in a variety of configurations of chassis 100. As such, the preferred initialization point for method 700 and the order of the steps comprising method 700 may depend on the implementation chosen.

At step 702, a user may upload to RAC 512 a firmware image for a chassis-level information handling resource 534. Such firmware image may include updated firmware for such information handling resource 534. A user may upload the firmware image to RAC 512 in any suitable manner, including without limitation, by issuing proper commands via user interface 116 or a keyboard-video-mouse interface (not explicitly shown) coupled to chassis 100 or a chassis drawer 104 including such RAC 512. Such file may be uploaded from a readily-removable computer-readable medium (e.g., flash drive, secure digital (SD) card, etc.), communicatively coupled to RAC 512 via a suitable external media interface (e.g., Universal Serial Bus port, SE port) of chassis 100 or a chassis drawer 104 including such RAC 512 (not explicitly shown). During upload, the user may also provide an indication regarding to which information handling resource 534 the firmware image is to be applied. Alternatively, the firmware image itself, or metadata associated therewith, may indicate to which information handling resource 534 the firmware image is to be applied.

At step 704, RAC 512 may communicate to a CMC 112 (e.g., via out-of-bound switch 518) an indication that such a firmware update is to be applied to one or more information handling resources 534. Such indication may include an IPMI over LAN command or other suitable command communicated between RAC 512 and CMC 112 via out-of-band switch 518.

At step 706, responsive to receipt of the indication from RAC 512 that a firmware update is available, CMC 112 may retrieve the firmware image from RAC 512. Such transfer may be performed using trivial file transfer protocol (TFTP), IPMI over LAN, or other suitable protocol or standard for file transfer.

At step 708, responsive to receipt of the firmware image, CMC 112 may perform the firmware update by applying the firmware image to the appropriate information handling resource 534. During such firmware update, CMC 112 may, from time-to-time communicate an indication to RAC 512 regarding the status of the update. Such indication may include an IPMI over LAN command or other suitable command communicated between RAC 512 and CMC 112 via out-of-band switch 518. Accordingly, a RAC 512 may perform firmware updates and manage chassis 100 components in the same fashion as it would in a rack server, with CMC 112 serving as an intermediary between information handling resources 534 and RAC 512.

Although FIGURE 7 discloses a particular number of steps to be taken with respect to method 700, method 700 may be executed with greater or fewer steps than those depicted in FIGURE 7. In addition, although FIGURE 7 discloses a certain order of steps to be taken with respect to method 700, the steps comprising method 700 may be completed in any suitable order.

Method 700 may be implemented using CMC 112, a remote access controller 512, and/or any other system operable to implement method 700. In certain embodiments, method 700 may be implemented partially or fully in software and/or firmware embodied in computer-readable media and executable on a processor or controller.

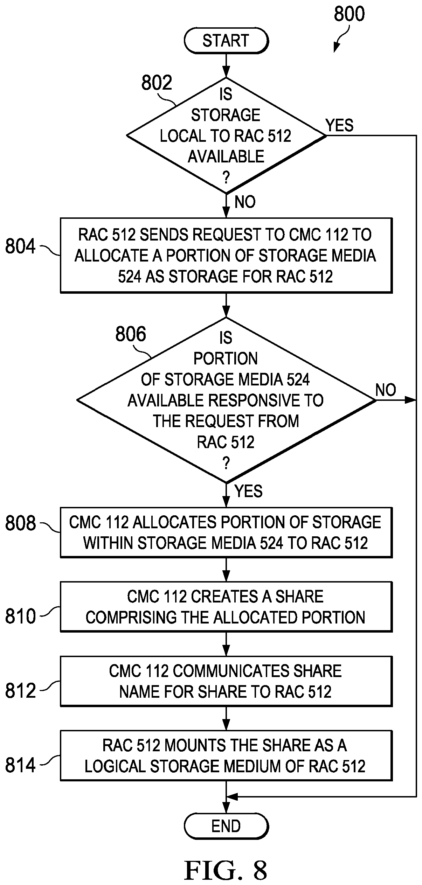

FIGURE 8 illustrates a flow chart of an example method 800 for allocation of storage media 524 associated with CMC 112 to a RAC 512, in accordance with examples of the present disclosure. According to some embodiments, method 800 may begin at step 802. As noted above, teachings of the present disclosure may be implemented in a variety of configurations of chassis 100. As such, the preferred initialization point for method 800 and the order of the steps comprising method 800 may depend on the implementation chosen.

At step 802, a RAC 512 may determine if storage local to RAC 512 (e.g., within the chassis drawer 104 comprising the RAC 512) is present and available. If local storage is not available, method 800 may proceed to step 804. Otherwise, method 800 may end.

At step 804, in response to storage local to RAC 512 being available, RAC 512 may send a request to CMC 112 (e.g., via out-of-band switch 518) to allocate a portion of storage media 524 as storage for RAC 512. Such request may include an IPMI over LAN command or other suitable command communicated between RAC 512 and CMC 112 via out-of-band switch 518.

At step 806, responsive to the request from RAC 512, CMC 112 may determine if a portion of storage media 524 is available responsive to the request from RAC 512. If a portion of storage media 524 is available, method 800 may proceed to step 808. Otherwise, method 800 may end.

At step 808, CMC 112 may allocate a portion of storage within storage media 524 to RAC 512. At step 810, CMC 112 may create a share (e.g., a Network File System (NFS) share) comprising the allocated portion. At step 812, CMC 112 may communicate the share name or other identifying information for the created share to RAC 512. Such communication may include an IPMI over LAN command or other suitable command communicated between CMC 112 and RAC 512 via out-of-band switch 518.

At step 814, in response to receipt of the share name, RAC 512 may mount the share as a logical storage medium of RAC 512. Accordingly, should RAC 512 require file storage I/O, it may issue the appropriate I/O commands to the mounted share, and a portion of storage media 524 may serve as virtual storage for RAC 512.

Similarly, portions of storage media 524 may also be allocated for a plurality of RACs 512 present in chassis 100 using methods similar to those described with respect to method 800.

Although FIGURE 8 discloses a particular number of steps to be taken with respect to method 800, method 800 may be executed with greater or fewer steps than those depicted in FIGURE 8. In addition, although FIGURE 8 discloses a certain order of steps to be taken with respect to method 800, the steps comprising method 800 may be completed in any suitable order.

Method 800 may be implemented using CMC 112, a remote access controller 512, and/or any other system operable to implement method 800. In certain embodiments, method 800 may be implemented partially or fully in software and/or firmware embodied in computer-readable media and executable on a processor or controller.

Although the present disclosure has been described in detail, it should be understood that various changes, substitutions, and alterations can be made hereto without departing from the scope of the disclosure as defined by the appended claims.

## Claims

1. A method to provide a management console for a user or administrator, comprising, in a chassis (100) having a plurality of slots (106) each configured to receive a module (104) having one or more information handling systems (502) wherein each slot (106) is configured to electrically and communicatively couple the module (104) to other components of the chassis (100):
receiving, by a chassis management controller (112) integral to the chassis (100), a signal from a sensor (532) integral to the chassis (100), the signal indicative of a physical quantity measured by the sensor (532); **characterized by**
communicating, from the chassis management controller (112) to a remote access controller (512) integral to at least one module (104) disposed in the plurality of slots (106), sensor information in conformity with the signal, wherein the chassis management controller (112) is configured to serve as a proxy between the sensor (532) and the remote access controller (512), wherein the chassis management controller (112) interfaces with a network interface separate from a network interface of the chassis (100), which allows out-of-band control of the chassis (100) such that communications to and from the chassis management controller (112) are communicated via a management channel physically isolated from an in-band communication channel with the network interface of the chassis (100).

2. The method of Claim 1, further comprising:
determining, by the chassis management controller (112), whether the measured physical quantity has changed by at least a threshold amount based on the signal; and
responsive to a determination that the measured physical quantity has changed by at least the threshold amount, communicating to the remote access controller (512) an indication that the measured physical quantity has changed.

3. The method of Claim 2, further comprising receiving a request at the chassis management controller (112) from the remote access controller (512) to communicate the sensor information to the remote access controller (512), wherein the request is sent by the remote access controller (512) in response to the indication and further wherein communicating the sensor information is responsive to receiving the request.

4. The method of Claim 1, wherein the chassis management controller (112) and the remote access controller (512) are communicatively coupled via an internal private network integral to the chassis (100).

5. A chassis (100) having a plurality of slots (106) each configured to receive a module (104) having one or more information handling systems (502), wherein each slot (106) is configured to electrically and communicatively couple the module (104) to other components of the chassis (100), said chassis (100) comprising a chassis management controller (112) integral to the chassis (100), a sensor (532) integral to the chassis (100), and a network interface (508),
the chassis (100) having a module (104) disposed in one of the plurality of slots (106), the module (104) having one or more information handling systems, the module (104) comprising a remote access controller (512) integral to the module (104),
the chassis management controller (112) being configured to serve as a proxy between the sensor (532) and the remote access controller (512),
the chassis management controller (112) comprising a management port (528) configured to serve as a network interface between the chassis management controller (112) and a remote management console,
the chassis being configured to carry out the method of any one of claims 1-4.

## Patentansprüche

1. Verfahren zum Bereitstellen einer Verwaltungskonsole für einen Benutzer oder Administrator, umfassend in einem Chassis (100), das einer Vielzahl von Steckplätzen (106) aufweist, die jeweils für die Aufnahme eines Moduls (104), das einen oder mehrere Informationsverarbeitungssysteme (502) aufweist, konfiguriert sind, wobei jeder Steckplatz (106) dazu konfiguriert ist, das Modul (104) elektrisch und kommunikativ mit anderen Komponenten des Chassis (100) zu koppeln:
Empfangen, durch einen in das Chassis (100) integrierten Chassisverwaltungscontroller (112), eines Signals von einem in das Chassis (100) integrierten Sensor (532), wobei das Signal eine von dem Sensor (532) gemessene physikalische Größe angibt; **gekennzeichnet durch**
Kommunizieren von dem Chassisverwaltungscontroller (112) zu einem Fernzugriff-Controller (512), der in mindestens einem Modul (104) integriert ist, das in der Vielzahl von Steckplätzen (106) angeordnet ist , Sensorinformationen in Übereinstimmung mit dem Signal, wobei der Chassisverwaltungscontroller (112) so konfiguriert ist, dass er als Proxy zwischen dem Sensor (532) und dem Fernzugriff-Controller (512) dient, wobei der Chassisverwaltungscontroller (112) Schnittstellen mit einer Netzwerkschnittstelle, die von einer Netzwerkschnittstelle des Chassis (100) getrennt ist, was eine Out-of-Band-Steuerung des Chassis (100) ermöglicht, sodass die Kommunikation zu dem und von dem Chassisverwaltungscontroller (112) über einen Verwaltungskanal kommuniziert wird, der physisch von einem In-Band-Kommunikationskanal mit der Netzwerkschnittstelle des Chassis (100) isoliert ist.

2. Verfahren nach Anspruch 1, ferner umfassend:
Bestimmen, durch den Chassisverwaltungscontroller (112), ob sich die gemessene physikalische Größe auf der Grundlage des Signals um mindestens einen Schwellenbetrag geändert hat; und
als Reaktion auf die Bestimmung, dass sich die gemessene physikalische Größe um mindestens den Schwellenbetrag geändert hat, Übermitteln eines Hinweises an den Fernzugriff-Controller (512), dass sich die gemessene physikalische Größe geändert hat.

3. Verfahren nach Anspruch 2, ferner umfassend Empfangen einer Anfrage von dem Fernzugriff-Controller (512) an dem Chassisverwaltungscontroller (112), um die Sensorinformationen an den Fernzugriff-Controller (512) zu übermitteln, wobei die Anfrage von dem Fernzugriff-Controller (512) als Reaktion auf den Hinweis gesendet wird und ferner die Kommunikation der Sensorinformationen weiterhin auf das Empfangen der Anfrage reagiert.

4. Verfahren nach Anspruch 1, wobei der Chassisverwaltungscontroller (112) und der Fernzugriff-Controller (512) über ein internes privates Netzwerk, das in das Chassis (100) integriert ist, kommunikativ gekoppelt sind.

5. Chassis (100), das eine Vielzahl von Steckplätzen (106) aufweist, die jeweils zur Aufnahme eines Moduls (104) mit einem oder mehreren Informationsverarbeitungssystemen (502) konfiguriert sind, wobei jeder Steckplatz (106) zum elektrischen und kommunikativen Koppeln des Moduls (104) mit anderen Komponenten des Chassis (100) konfiguriert ist, wobei das Chassis (100) einen in das Chassis (100) integrierten Chassisverwaltungscontroller (112), einen in das Chassis (100) integrierten Sensor (532) und eine Netzwerkschnittstelle (508) umfasst,
wobei das Chassis (100) ein Modul (104) aufweist, das in einem der Vielzahl von Steckplätzen (106) angeordnet ist, wobei das Modul (104) ein oder mehrere Informationsverarbeitungssysteme aufweist, das Modul (104) einen in das Modul (104) integrierten Fernzugriff-Controller (512) umfasst,
wobei der Chassisverwaltungscontroller (112) so konfiguriert ist, dass er als Proxy zwischen dem Sensor (532) und dem Fernzugriff-Controller (512) dient,
wobei der Chassisverwaltungscontroller (112) einen Verwaltungsport (528) umfasst, der so konfiguriert ist, dass er als Netzwerkschnittstelle zwischen dem Chassisverwaltungscontroller (112) und einer Fern-Verwaltungskonsole dient,
wobei das Chassis so konfiguriert ist, dass es das Verfahren nach einem der Ansprüche 1-4 ausführt.

## Revendications

1. Procédé de fourniture d'une console de gestion à un utilisateur ou à un administrateur, comprenant, dans un châssis (100) présentant une pluralité de fentes (106), chacune étant configurée pour recevoir un module (104) présentant un ou plusieurs systèmes de gestion d'informations (502) dans lequel chaque fente (106) est configurée pour coupler électriquement et de manière communicative le module (104) à d'autres composants du châssis (100) :
la réception, par un dispositif de commande de gestion de châssis (112) intégré au châssis (100), d'un signal provenant d'un capteur (532) intégré au châssis (100), du signal indiquant une grandeur physique mesurée par le capteur (532) ; **caractérisé par**
la communication, en provenance du dispositif de commande de gestion de châssis (112) et à destination d'un dispositif de commande d'accès à distance (512) intégré à au moins un module (104) disposé dans la pluralité de fentes (106), d'informations de capteur conformes au signal, dans lequel le dispositif de commande de gestion de châssis (112) est configuré pour servir de proxy entre le capteur (532) et le dispositif de commande d'accès à distance (512), dans lequel le dispositif de commande de gestion de châssis (112) interagit avec une interface réseau distincte d'une interface réseau du châssis (100), ce qui permet une commande hors bande du châssis (100) de telle sorte que les communications à destination et en provenance du dispositif de commande de gestion de châssis (112) soient communiquées par l'intermédiaire d'un canal de gestion physiquement isolé d'un canal de communication en bande avec l'interface réseau du châssis (100).

2. Procédé selon la revendication 1, comprenant également :
la détermination, par le dispositif de commande de gestion de châssis (112), du fait de savoir si la grandeur physique mesurée a changé d'au moins une quantité seuil en fonction du signal ; et
en réponse à une détermination du changement de la grandeur physique mesurée d'au moins la quantité seuil, la communication à destination du dispositif de commande d'accès à distance (512) d'une indication du changement de la grandeur physique mesurée.

3. Procédé selon la revendication 2, comprenant également la réception d'une requête au niveau du dispositif de commande de gestion de châssis (112) en provenance du dispositif de commande d'accès à distance (512) pour communiquer les informations de capteur au dispositif de commande d'accès à distance (512), dans lequel la requête est envoyée par le dispositif de commande d'accès à distance (512) en réponse à l'indication et également dans lequel la communication des informations de capteur est réalisée en réponse à la réception de la requête.

4. Procédé selon la revendication 1, dans lequel le dispositif de gestion de châssis (112) et le dispositif de commande d'accès à distance (512) sont couplés de manière communicative par l'intermédiaire d'un réseau privé interne intégré au châssis (100).

5. Châssis (100) présentant une pluralité de fentes (106), chacune étant configurée pour recevoir un module (104) présentant un ou plusieurs systèmes de gestion d'informations (502), dans lequel chaque fente (106) est configurée pour coupler électriquement et de manière communicative le module (104) à d'autres composants du châssis (100), ledit châssis (100) comprenant un dispositif de commande de gestion de châssis (112) intégré au châssis (100), un capteur (532) intégré au châssis (100), et une interface réseau (508),
le châssis (100) présentant un module (104) disposé dans l'une de la pluralité de fentes (106), le module (104) présentant un ou plusieurs systèmes de traitement d'informations, le module (104) comprenant un dispositif de commande d'accès à distance (512) intégré au module (104),
le dispositif de commande de gestion de châssis (112) étant configuré pour servir de proxy entre le capteur (532) et le dispositif de commande d'accès à distance (512),
le dispositif de commande de gestion de châssis (112) comprenant un port de gestion (528) configuré pour servir d'interface réseau entre le dispositif de commande de gestion de châssis (112) et une console de gestion à distance,
le châssis étant configuré pour exécuter le procédé selon l'une quelconque des revendications 1 à 4.
